# EUROPÄISCHE PATENTANMELDUNG

(11) **EP 1 693 935 A1**
(43) Veröffentlichungstag der Anmeldung: **23.08.2006**
(21) Anmeldenummer: 06002798.4
(22) Anmeldetag: 11.02.2006
(51) Int. Cl.: H01S 5/042, H01S 5/0683

(54) **Bestimmung der Laserschwelle einer Laserdiode**

(30) Priorität: 18.02.2005 DE 102005009317
(71) Anmelder: ATMEL Germany GmbH, 74072 Heilbronn (DE)
(72) Erfinder: Knotz, Herbert, Ing., 89155 Erbach (DE)

(57) **Zusammenfassung**

Vorgestellt wird ein Verfahren zur Bestimmung der Laserschwelle einer Laserdiode (12), die von einer Treiberschaltung (36a) in Abhängigkeit von einem ersten Signal in einer ersten Rückführung (37) und einem zweiten Signal in einer zweiten Rückführung (39) betrieben wird, wobei die erste Rückführung (37) über eine optische Kopplung (28) von einem optischen Ausgangssignal der Laserdiode (12) gespeist wird. Das Verfahren zeichnet sich dadurch aus, dass die zweite Rückführung (39) von einem zwischen der Treiberschaltung (36a) und der Laserdiode (12) abgenommenen elektrischen Signal (f(I)) gespeist wird, das elektrische Signal (f(I)) mit einer einstellbaren Aktivierungsschwelle (SW2) verglichen wird, nur ein Anteil des elektrischen Signals (f(I)), der die einstellbare Aktivierungsschwelle (SW2) übersteigt, an die Treiberschaltung (36a) weitergegeben wird, so dass die zweite Rückführung (36a) nur beim Auftreten eines solchen Anteils aktiv ist, die einstellbare Aktivierungsschwelle (SW2) so verändert wird, dass sich der Aktivitätszustand der zweiten Rückführung (39) ändert, und die Laserschwelle (SW1) der Laserdiode (12) in Abhängigkeit von dem Wert der einstellbaren Aktivierungsschwelle (SW2) bei einer Änderung des Aktivitätszustandes der zweiten Rückführung (39) bestimmt wird. Ferner wird eine Treiberschaltung (36a) vorgestellt, die das Verfahren ausführt.

## Beschreibung

Die Erfindung betrifft ein Verfahren zur Bestimmung der Laserschwelle einer Laserdiode, die von einer Treiberschaltung in Abhängigkeit von einem ersten Signal in einer ersten Rückführung und einem zweiten Signal in einer zweiten Rückführung betrieben wird, wobei die erste Rückführung über eine optische Kopplung von einem optischen Ausgangssignal der Laserdiode gespeist wird.

Die Erfindung betrifft ferner eine Treiberschaltung, die die Laserschwelle einer Laserdiode bestimmt, wobei die Treiberschaltung ein Treibersignal und die Laserdiode ein vom Treibersignal abhängiges Ausgangssignal erzeugt, mit einer ersten Rückführung und einer zweiten Rückführung, wobei die erste Rückführung zur Einspeisung eines Teils des Ausgangssignals über eine optische Kopplung eingerichtet ist.

Ein solches Verfahren und eine solche Treiberschaltung ist jeweils aus der US 5,260,955 bekannt. Nach dieser Schrift weist die Lichtleistungs-Treiberstrom-Kennlinie einer Laserdiode einen unteren, nicht linearen Abschnitt kleiner Treiberströme und Lichtleistungen auf. Ferner weist die Kennlinie einen oberen Abschnitt größerer Treiberströme und Lichtleistungen auf, in dem die Lichtleistung zumindest näherungsweise linear vom Treiberstrom abhängt. Der lineare Abschnitt wird dort als lasing-region und der nicht lineare Bereich als light emitting oder spontaneous emission region bezeichnet. Beide Abschnitte werden durch einen Wert des Treiberstroms getrennt, der auch als Laserschwelle bezeichnet wird. Für die Steuerung der Laserdiode ist eine Kenntnis der Laserschwelle hilfreich.

Zur Bestimmung der Laserschwelle sind bei der US 5,260,955 zwei Rückführungen vorgesehen, die über einen gemeinsamen elektrischen Anschlussknoten an eine Fotodiode angeschlossen sind. Eine erste Rückführung dient zur Regelung der Leistung der Laserdiode im Betrieb der Laserdiode. Die zweite Rückführung dient zur Ermittlung der Laserschwelle. Dazu wird das Signal in der zweiten Rückführung mit einem festen Schwellenwert verglichen. Solange der Schwellenwert nicht überschritten wird, erfolgt sukzessive eine Erhöhung des Treiberstroms der Laserdiode. Wird der Schwellenwert, der mit einer bestimmten, von der Fotodiode empfangenen Lichtleistung korreliert, überschritten, wird der zugehörige Treiberstom ohne weitere Veränderungen beibehalten. Im Betrieb liefert die zweite Rückführung dann diesen Laserschwellen-Treiberstrom, während ein Referenzsignalgeber Steuersignale für Treiberstrombeiträge oberhalb der Laserschwelle liefert. Diese werden mit der ersten Rückführung stabilisiert.

Die Stabilisierung erfolgt bei bekannten Anordnungen aus Treiberschaltungen und Laserdioden auf folgende Weis: Die erste Rückführung ist an einen Rückführsignaleingang eines Differenzverstärkers angeschlossen und empfängt über die Fotodiode einen Teil der abgestrahlten Lichtleistung der Laserdiode. Dem Differenzverstärker wird ferner ein Referenzsignal zugeführt, das die Lichtleistung der Laserdiode steuert. Wenn die Laserdiode vergleichsweise viel Lichtleistung abstrahlt, liefert die Photodiode einen hohen Photostrom an den Rückführsignaleingang des Differenzverstärkers, was das Ausgangssignal des Differenzverstärkers verkleinert und damit die Lichtleistung der Laserdiode verringert. Entsprechend führt eine vergleichsweise geringe abgestrahlte Lichtleistung zu einer Vergrößerung der Differenz und damit zu einer Vergrößerung der Lichtleistung. Die Rückführung schließt damit einen Regelkreis, durch den sich im eingeschwungenen Zustand eine stabile Lichtleistung einstellt.

Die Laserschwellen zu treibender individueller Laserdioden können auch bei Laserdioden gleichen Typs individuell verschieden sein und sich zusätzlich durch Alterungseinflüsse verändern. Bei einem hier als Beispiel dienenden Typ von Laserdioden kann die individuelle Laserschwelle einer individuellen Laserdiode zum Beispiel in einem Bereich von Treiberstromstärken zwischen 10 mA und 50 mA liegen. Um mit definierten Treibersignalen definierte Ausgangssignale erzeugen zu können, ist daher eine Kenntnis der individuellen Laserschwelle einer Laserdiode hilfreich. Dies gilt ganz allgemein auch für andere Bauteile, die eine Aktivierungsschwelle aufweisen oder für Anordnungen aus einem Differenzverstärker und einer Laserdiode. Bei einer solchen Anordnung hängt die Treiberstromstärke, bei der ein Lasereffekt in der Laserdiode einsetzt, zusätzlich vom Offsetstrom des Verstärkers ab. Wenn im Folgenden ein Ausgangssignal einer Laserdiode genannt wird, ist in der Regel eine oberhalb der Laserschwelle oder Aktivierungsschwelle liegende Lichtleistung gemeint.

Für eine möglichst genaue Steuerung der Lichtleistung der Laserdiode und damit der Ausgangssignale der Laserdiode ist eine Kenntnis der mit einer Toleranz behafteten Laserschwelle wünschenswert.

Außerdem weisen Treiberstromquellen, zum Beispiel verschiedene Exemplare des genannten Differenzverstärkers, häufig ebenfalls Streuungen in ihrem Eingangs-/AusgangsSignalverhalten auf, die für eine definierte Funktion des Bauteils durch Abgleich der Differenzverstärker zu kompensieren sind. Dieser Abgleich kann umso genauer erfolgen, je besser die Betriebsbedingung des Differenzverstärkers beim Abgleich mit den Betriebsbedingungen im späteren Betrieb übereinstimmen. Da im späteren Betrieb Treiberstromstärken in der Größenordnung der Laserschwelle bereitzustellen sind, sollte der Abgleich möglichst nahe an der Laserschwelle erfolgen. Auch aus diesem Grund ist eine Kenntnis der Laserschwelle wünschenswert.

Bei dem aus der US 5, 260, 955 bekannten Verfahren wird zur Ermittlung der Laserschwelle mit dem Treibersignal eine gewisse Signalbandbreite durchfahren und dabei eine Aktivität im Signalweg hinter der optischen Kopplung zwischen Laserdiode und Fotodiode durch einen Schwellenwertvergleich erfasst. In der Praxis reagiert eine solche, eine optische Kopplung aufweisende Rückführung insbesondere bei Laserdioden sehr empfindlich auf Messeingriffe. Eine ausreichende Zuverlässigkeit und Genauigkeit der erhaltenen Ergebnisse ist daher nicht ohne weiteres gewährleistet.

Vor diesem Hintergrund besteht die Aufgabe der Erfindung in der Angabe eines Verfahrens und einer Treiberschaltung, mit denen sich jeweils individuelle Aktivierungsschwellen individueller Bauteile, insbesondere individuelle Laserschwellen individueller Laserdioden, reproduzierbar genau und zuverlässig ermitteln lassen.

Diese Aufgabe wird bei einem Verfahren der eingangs genannten Art dadurch gelöst, dass die zweite Rückführung von einem zwischen der Treiberschaltung und der Laserdiode abgenommenen elektrischen Signal gespeist wird, das elektrische Signal mit einer einstellbaren Aktivierungsschwelle (SW2) verglichen wird, nur ein Anteil des elektrischen Signals, der die einstellbare Aktivierungsschwelle (SW2) übersteigt, an die Treiberschaltung weitergegeben wird, so dass die zweite Rückführung nur beim Auftreten eines solchen Anteils aktiv ist, die einstellbare Aktivierungsschwelle (SW2) so verändert wird, dass sich der Aktivitätszustand der zweiten Rückführung ändert, und die Laserschwelle (SW1) der Laserdiode (12) in Abhängigkeit von dem Wert der einstellbaren Aktivierungsschwelle (SW2) bei einer Änderung des Aktivitätszustandes der zweiten Rückführung bestimmt wird.

Ferner wird diese Aufgabe bei einer Treiberschaltung der eingangs genannten Art dadurch gelöst, dass die zweite Rückführung durch einen elektrischen Anschluss an eine das Treibersignal führende Verbindung zwischen der Treiberschaltung und der Laserdiode zur Einspeisung eines elektrischen Signals eingerichtet ist, und ferner dazu eingerichtet ist, das elektrische Signal mit einer einstellbaren Aktivierungsschwelle zu vergleichen, nur einen Anteil des elektrischen Signals, der die einstellbare. Aktivierungsschwelle übersteigt, an die Treiberschaltung weiterzugeben, so dass die zweite Rückführung nur beim Auftreten eines solchen Anteils aktiv ist, die einstellbare Aktivierungsschwelle so zu verändern, dass sich der Aktivitätszustand der zweiten Rückführung ändert, und die Laserschwelle der Laserdiode in Abhängigkeit von dem Wert der einstellbaren Aktivierungsschwelle bei einer Änderung des Aktivitätszustandes der zweiten Rückführung zu bestimmen.

Dabei wird unter einer Änderung des Aktivitätszustandes bevorzugt ein Übergang zwischen einer aktiven und einer inaktiven zweiten Rückführung verstanden. Diese Merkmale erlauben eine Bestimmung der Laserschwelle oder einer ersten Aktivierungsschwelle ohne Eingriffe in den empfindlichen Signalweg hinter der optischen Kopplung zwischen Laserdiode und Fotodiode. Stattdessen erfolgt eine indirekte Erfassung der Laserschwelle in der zweiten Rückführung, die mit der ersten Rückführung um eine Beeinflussung des Rückführsignals konkurriert und die robuster auf Messeingriffe reagiert. Die Konkurrenz der Rückführungen gewinnt immer diejenige Rückführung, deren Schwelle (Laserschwelle oder zweite Aktivierungsschwelle) kleiner ist. Ist die zweite Aktivierungsschwelle zum Beispiel größer als die Laserschwelle , so gibt die Laserdiode ein Ausgangssignal ab, das über die erste Rückführung stabilisiert wird. Die zweite Rückführung ist dann nicht aktiv, was einem ersten Aktivitätszustand entspricht.

Bei einer Verkleinerung der zweiten Aktivierungsschwelle auf Werte unterhalb der Laserschwelle schwingt sich die Anordnung dagegen auf die jetzt kleinere zweite Aktivierungsschwelle ein. Das Bauteil liefert dann kein Ausgangssignal mehr. Als Folge ist die erste Rückführung nicht aktiv, während die zweite Rückführung ein Signal führt und daher aktiv ist. Durch Variation der einstellbaren Aktivierungsschwelle ändert sich der Aktivitätszustand der zweiten Rückführung daher genau bei dem Wert der Laserschwelle. Daher erlaubt die Erfindung eine indirekte, reproduzierbar genaue und zuverlässige Bestimmung der Laserschwelle durch einen Messeingriff in der zweiten Rückführung, die elektrisch von der optischen Kopplung unabhängig ist.

Optische Kopplungen erzeugen in der Regel nur kleine elektrische Signale und reagieren daher häufig empfindlich auf Messeingriffe. Die indirekte Messung stellt daher in diesem Anwendungsfall eine Möglichkeit zur zuverlässigen und reproduzierbar genauen Bestimmung der Laserschwelle dar.

Bevorzugt ist auch, dass die zweite Rückführung ein Schwellenwertfilter aufweist, das nur Signale passieren lässt, die den einstellbaren Schwellenwert überschreiten.

Diese Ausgestaltung stellt eine einfache schaltungstechnische Realisierung einer einstellbaren Aktivierungsschwelle dar.

Eine weitere bevorzugte Treiberschaltung zeichnet sich durch eine steuerbare Stromquelle als Schwellenwertfilter aus, die einen Strom bis zu einer dem einstellbaren Schwellenwert entsprechenden Stromstärke aufnimmt oder ausgibt.

Diese Ausgestaltung stellt eine besonders einfache und kontinuierliche Form der Schwellenwertfilterung dar. Die Stromquelle kann z.B. als Quelle negativer Ströme, also als Stromsenke, realisiert sein, die an die zweite Rückführung angeschlossen ist und kleine Ströme aufnimmt und nur den über ihren Maximalstrom hinausgehenden Strom in der Rückführung vorbeilässt.

Bevorzugt ist auch, dass die Treiberschaltung einen Differenzverstärker mit einem Ausgang, der das Treibersignal bereitstellt, einem Referenzsignaleingang, der von einem Referenzsignalgenerator gespeist wird und einem Rückführsignaleingang, der sowohl mit der ersten Rückführung als auch mit der zweiten Rückführung gekoppelt ist, aufweist,

Diese Ausgestaltung stellt eine einfache schaltungstechnische Realisierung dar, mit der zwischen den beiden Rückführungen eine Konkurrenz erzeugt wird.

Ferner ist bevorzugt, dass die zweite Rückführung eine Auskoppelschaltung aufweist, die ein Rückführsignal aus der zweiten Rückführung auskoppelt und der Teilschaltung zuführt.

Durch eine solche parallel zur Weiterleitung des Rückführsignals in der zweiten Rückführung erfolgende Auskopplung kann die Bestimmung der ersten Aktivierungsschwelle in einem Abgleichmodus kontinuierlich und ohne störende Beeinflussung der Schleife aus Differenzverstärker und zweiter Rückführung erfolgen.

Bevorzugt ist auch, dass die Auskoppelschaltung einen Stromspiegel aufweist, der einen aus dem Differenzverstärker in die zweite Rückführung eingespeisten Strom sowohl in einen zum Rückführsignaleingang führenden Stromzweig als auch in einen Messzweig der Teilschaltung abbildet.

Die Auskopplung mit dem Stromspiegel hat den Vorteil, dass sich durch Anzahl und Dimensionierung der verwendeten Elemente beliebige Übersetzungsverhältnisse zwischen den Strömen in verschiedenen Zweigen des Stromspiegels einstellen lassen. Daher kann zum Beispiel sowohl die Dämpfung der Signalrückführung als auch ein je nach Bedarf ausreichend großer Strom im Messzweig eingestellt werden.

Ferner ist bevorzugt, dass die Teilschaltung einen Detektor aufweist, der eine Signalstärke des ausgekoppelten Rückführsignals erfasst und an eine Steuerung übergibt.

Diese Ausgestaltung stellt eine einfache schaltungstechnische Realisierung einer indirekten Erfassung der ersten Aktivierungsschwelle dar.

Eine weitere Ausgestaltung sieht vor, dass der Detektor die Signalstärke periodisch abtastet.

Durch die periodische Abtastung wird eine Folge diskreter Messwerte bei minimaler Wechselwirkung mit dem Strom im Messzweig erzeugt.

Bevorzugt ist auch, dass der Detektor als getakteter Komparator ausgeführt ist, weil dieser eine sehr hohe Empfindlichkeit besitzt. Dies erlaubt eine Minimierung der Wechselwirkung des Messeingriffs mit der zweiten Rückführung.

Eine weitere Ausgestaltung zeichnet sich dadurch aus, dass sie eine Kompensationssignalquelle aufweist und ferner dadurch, dass die Teilschaltung nach Abspeicherung des Maßes für eine erste Aktivierungsschwelle unter Verwendung dieses Maßes ein Kompensationssignal bildet und speichert, das die erste Aktivierungsschwelle bis auf einen definierten Rest-Offset kompensiert, und dadurch, dass die Teilschaltung das gespeicherte Kompensationssignal zusätzlich zu einem vom Referenzsignalgenerator gelieferten Referenzsignal in den Referenzeingang, oder den Rückführsignaleingang einspeist. Der genannte Rest-Offset kann zum Beispiel durch einen dritten Schwellenwert hervorgerufen werden, der bei der Überprüfung der Aktivität der zweiten Rückführung wirksam ist. Diese Überprüfung wird weiter unten näher erläutert.

Durch diese Ausgestaltung übernimmt das Kompensationssignal gewissermaßen die Bereitstellung eines Treibersignalanteils, der der ersten Aktivierungsschwelle entspricht. Die erste Aktivierungsschwelle stellt gewissermaßen die Laserschwelle der Laserdiode in der Anordnung mit einem Offset-behafteten Verstärker dar. Der Referenzsignalgenerator muss dann nur den Treibersignalanteil bereitstellen, mit dem Veränderungen des Ausgangssignals des Bauteils gesteuert werden. Als Folge ergibt sich eine verbesserte Steuerbarkeit von Veränderungen des Ausgangssignals.

Weitere Vorteile ergeben sich aus der Beschreibung und den beigefügten Figuren.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

### Zeichnungen

Ausführungsbeispiele der Erfindung sind in den Zeichnungen dargestellt und werden in der nachfolgenden Beschreibung näher erläutert. Es zeigen, jeweils in schematischer Form:
- Fig. 1: eine bekannte Anordnung einer Treiberschaltung mit einer ersten Rückführung;
- Fig. 2: eine reale und eine idealisierte Kennlinie einer Laserdiode;
- Fig. 3: Kennlinien einer Anordnung aus einer Laserdiode und einem Differenzverstärker;
- Fig.4: Blockschaltbilder von Ausführungsbeispielen einer erfindungsgemäßen Treiberschaltung; und
- Fig.: 5 eine schaltungstechnische Realisierung eines Ausführungsbeispiels einer erfindungsgemäßen Treiberschaltung.

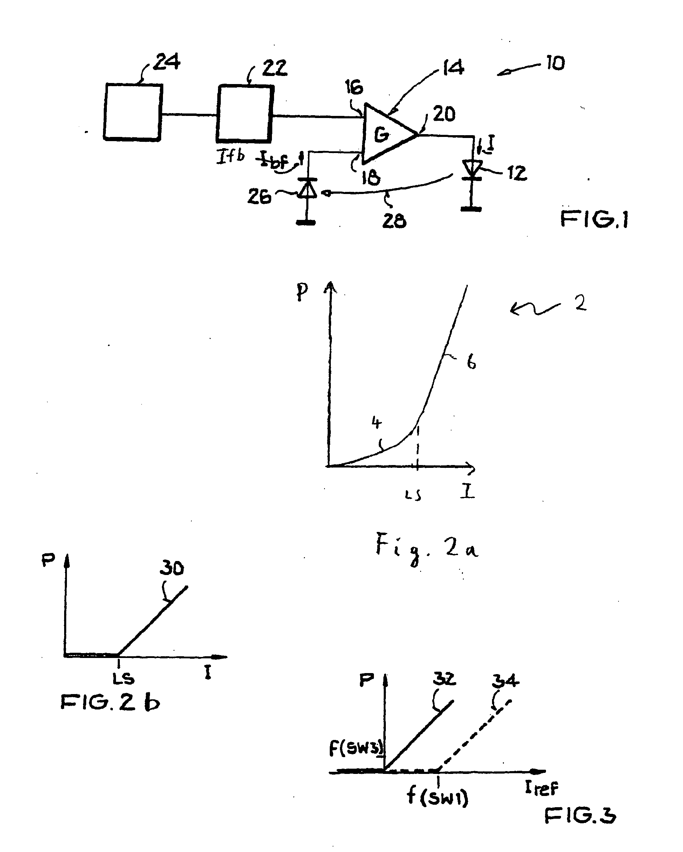

Figur 1 zeigt eine bekannte Treiberschaltung 10, die eine Laserdiode 12 treibt. Die Treiberschaltung 10 besitzt einen Differenzverstärker 14, der einen Referenzsignaleingang 16, einen Rückführsignaleingang 18 und einen Ausgang 20 aufweist, sowie einen Referenzsignalgenerator 22, eine Steuerung 24 und eine Fotodiode 26. Der Referenzsignaleingang 16 wird von dem Referenzsignalgenerator 22 gespeist, der durch die Steuerung 24 gesteuert wird. An den Rückführsignaleingang 18 ist die Fotodiode 26 angeschlossen, die im Betrieb der Treiberschaltung 10 und der Laserdiode 12 einen Teil der von der Laserdiode 12 abgestrahlten Lichtleistung durch eine optische Kopplung 28 empfängt und in einen Fotostrom umwandelt. Der Fotostrom dient als Rückführsignal Ifb. Der Differenzverstärker 14 stellt einen Strom I als Treibersignal für die Laserdiode 12 bereit, der vom Verstärkungsfaktor G des Differenzverstärkers 14 und der Differenz der Signale am Referenzsignaleingang 16 und Rückführsignaleingang 18 abhängt. Auf diese Weise wird die von der Laserdiode 12 abgestrahlte Leistung und die Signalform des optischen Ausgangssignals von dem Referenzsignalgenerator 22 und der Steuerung 24 bestimmt und in einer ersten Rückführung, die über die optische Kopplung 28 zwischen der Laserdiode 12 und der Fotodiode 26 geschlossen wird, geregelt.

Figur 2a zeigt eine reale Kennlinie 2 der Laserdiode 12. Dabei ist eine Lichtleistung P der Laserdiode 12 über dem treibenden Eingangssignal I aufgetragen. Die Kennlinie 2 weist einen unteren, nicht linearen Abschnitt 4 kleiner Treiberströme und Lichtleistungen auf. Ferner weist die Kennlinie 2 einen oberen Abschnitt 6 größerer Treiberströme und Lichtleistungen auf, in dem die Lichtleistung P zumindest näherungsweise linear vom Treiberstrom I abhängt. Der lineare Abschnitt 6 ist die lasing-region und der nicht lineare Abschnitt 4 ist die light emitting oder spontaneous emission region. Beide Abschnitte 4, 6 werden durch einen Wert des Treiberstroms I getrennt, der auch als Laserschwelle LS bezeichnet wird. Für die Steuerung der Laserdiode 12 ist eine Kenntnis der Laserschwelle LS hilfreich.

Figur 2b zeigt eine idealisierte Kennlinie 30 der Laserdiode 12. Wieder ist eine Lichtleistung P der Laserdiode 12 über dem treibenden Eingangssignal I aufgetragen. Bei der idealisierten Kennlinie 30 ist der Abschnitt 4 der Kennlinie 2 aus Fig. 2a, also der Bereich der spontanen Emission, als I-Achsen-parallele Gerade mit dem Wert Null dargestellt. Bei dieser idealisierten aber nicht unüblichen Darstellung tritt eine Lichtleistung P erst dann auf, wenn das Treibersignal I eine Laserschwelle LS überschreitet. Dieser Verlauf entspricht der oben genannten und durchaus üblichen Konvention, nach der nur Lichtleistungen aus dem Kennlinienabschnitt oberhalb der Laserschwelle als Ausgangssignale betrachtet werden. Auf den Gegenstand der Fig. 3 wird weiter unten Bezug genommen.

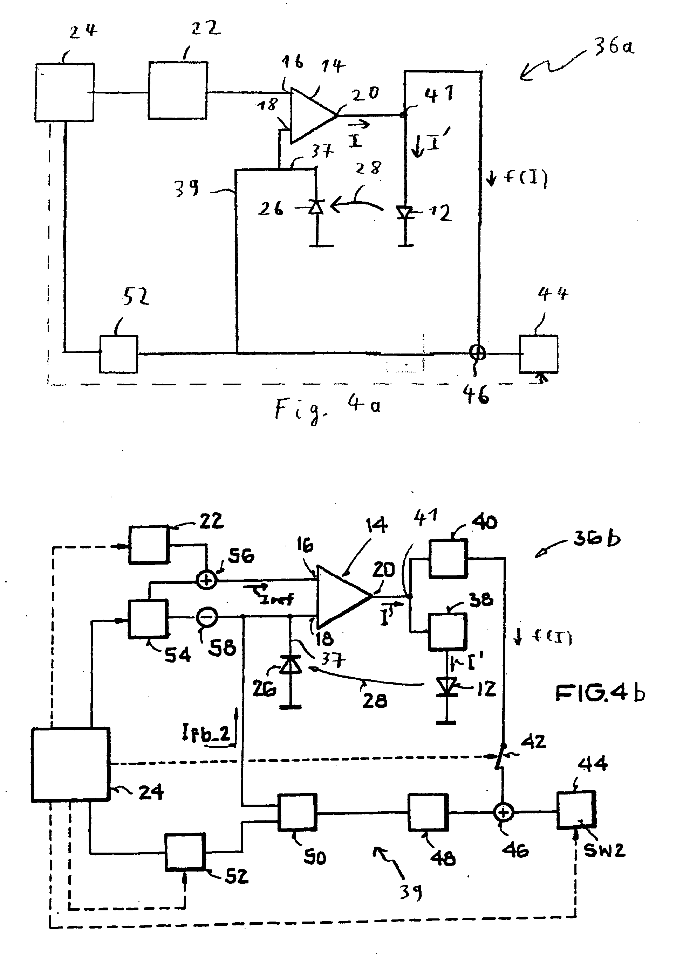

Figur 4 zeigt Blockschaltbilder von Ausführungsbeispielen einer Treiberschaltung, mit der sich die Laserschwelle LS bestimmen lässt. Durch die Blockschaltbilder werden damit gleichzeitig Vorrichtungsaspekte und Verfahrensaspekte dargestellt. Im Einzelnen zeigt Fig. 4a eine Treiberschaltung 36a, die die Laserschwelle LS der Laserdiode 12 bestimmt. Die Treiberschaltung 36a basiert auf der bekannten Treiberschaltung 10 aus der Figur 1 und weist daher u. a. eine Laserdiode 12, einen Differenzverstärker 14 mit Referenzsignaleingang 16, Rückführsignaleingang 18 und Ausgang 20, einen Referenzsignalgenerator 22, eine Steuerung 24 und eine Fotodiode 26 auf, die an den Rückführsignaleingang 18 des Differenzverstärkers 14 angeschlossen ist. Im Übrigen bezeichnen gleiche Bezugszeichen in den Figuren jeweils gleiche Gegenstände. Die Treiberschaltung 36a erzeugt ein Treibersignal I, I' und die Laserdiode 12 erzeugt ein vom Treibersignal I, I' abhängiges Ausgangssignal, das über die optische Kopplung 28 auf die Fotodiode 26 einwirkt. Die Treiberschaltung 36a weist ferner eine erste Rückführung 37 und eine zweite Rückführung 39 auf, wobei die erste Rückführung 37 zur Einspeisung eines Teils des Ausgangssignals der Laserdiode 12 über die optische Kopplung 28 eingerichtet ist.

Die zweite Rückführung 39 ist dagegen durch einen elektrischen Anschluss 41 an eine das Treibersignal I, I' führende Verbindung zwischen der Treiberschaltung 36a und der Laserdiode 12 zur Einspeisung eines elektrischen Signals eingerichtet. In der Ausgestaltung der Fig. 4a liegt der Anschluss 41 zwischen dem Ausgang 20 des Differenzverstärkers 14 und der Laserdiode 12. Die zweite Rückführung 39 ist ferner dazu eingerichtet, das elektrische Signal mit einer einstellbaren Aktivierungsschwelle SW2 zu vergleichen, nur einen Anteil des elektrischen Signals, der die einstellbare Aktivierungsschwelle SW2 übersteigt, an die Treiberschaltung weiterzugeben, so dass die zweite Rückführung nur beim Auftreten eines solchen Anteils aktiv ist, die einstellbare Aktivierungsschwelle SW2 so zu verändern, dass sich der Aktivitätszustand der zweiten Rückführung ändert, und die Laserschwelle LS der Laserdiode 12 in Abhängigkeit von dem Wert der einstellbaren Aktivierungsschwelle SW2 bei einer Änderung des Aktivitätszustandes der zweiten Rückführung 39 zu bestimmen. Die einstellbare Aktivierungsschwelle SW2 wird von einem Schwellenwertfilter 44 bereitgestellt und in einer Schwellenwertverknüpfung 46 mit dem elektrischen Signal vom Anschluss 41 verknüpft. Dabei ist die einstellbare Aktivierungsschwelle SW2 in einem Ermittlungsmodus zum Beispiel zunächst kleiner als die Laserschwelle LS, die in der ersten Rückführung wirksam ist. Je nach Ausgestaltung kann aber auch mit einer zweiten Aktivierungsschwelle SW2 begonnen werden, die größer als die Laserschwelle ist. Die zweite Aktivierungsschwelle wird dann sukzessive verkleinert, bis eine Änderung der Aktivität der zweiten Rückführung eintritt.

Das in die zweite Rückführung 39 eingekoppelte Signal f(I) wird in der Schwellenwertverknüpfung 46 mit der anfänglich vergleichsweise niedrigen einstellbaren Aktivierungsschwelle SW2 des Schwellenwertfilters 44 verknüpft. Dabei kann die Verknüpfung z. B. so geschehen, dass das Schwellenwertfilter 44 einen Strom bis zu einem vorgegebenen Maximalwert von der Schwellenwertverknüpfung 46 ziehen kann, so dass die Schwellenwertverknüpfung 46 nur dann einen Signalanteil weitergibt, wenn der durch das Schwellenwertfilter 44 vorgegebene Maximalwert durch das Signal f(I) überschritten wird.

Zur Ermittlung der Laserschwelle LS wird damit das elektrische Signal f(I) mit einer einstellbaren Aktivierungsschwelle SW2 verglichen und nur der Anteil des elektrischen Signals f(I), der die einstellbare Aktivierungsschwelle SW2 übersteigt, an die übrige Treiberschaltung 36a weitergegeben. Die zweite Rückführung 39 ist daher nur beim Auftreten eines solchen Anteils aktiv. Ferner wird die einstellbare Aktivierungsschwelle SW2 von der Steuerung 24 so verändert, dass sich der Aktivitätszustand der zweiten Rückführung 39 ändert. Dies wird in der Fig. 4a durch die gestrichelte Linie zwischen der Steuerung 24 und dem Schwellenwertfilter 44 repräsentiert. Die Aktivität der zweiten Rückführung 39 wird vom Block 52 überwacht, der zum Beispiel das Vorhandensein eines Rückführsignals vorbestimmter Mindest-Signalstärke prüft. Die Laserschwelle LS der Laserdiode 12 wird dann in Abhängigkeit von dem Wert der einstellbaren Aktivierungsschwelle SW2 bei einer Änderung des Aktivitätszustandes der zweiten Rückführung bestimmt. Dabei ändert sich der Aktivitätszustand genau dann, wenn der Wert der zweiten Aktivierungsschwelle SW2 den Wert der Laserschwelle LS durchläuft.

Die Treiberschaltung 36b aus der Fig. 4b basiert ebenfalls auf der bekannten Treiberschaltung 10 aus der Figur 1 und weist daher u. a. die Laserdiode 12, den Differenzverstärker 14 mit Referenzsignaleingang 16, Rückführsignaleingang 18 und Ausgang 20, den Referenzsignalgenerator 22, die Steuerung 24 und die Fotodiode 26 auf, die an den Rückführsignaleingang 18 des Differenzverstärkers 14 angeschlossen ist. Die optische Kopplung 28 schließt die erste Rückführung 37.

Zusätzlich zu diesen Elementen weist die Treiberschaltung 36b noch eine Ausgangsstufe 38, eine zweite Rückführung 39 mit einem Anschluss 41 zwischen Differenzverstärkerausgang 20 und Laserdiode 12, einer Auskopplung 40, als Option einem Schalter 42, dem Schwellenwertfilter 44, der Schwellenwertverknüpfung 46, einer Dämpfung 48, und einer Auskoppelschaltung 50 auf. Ferner weist die Treiberschaltung 36b noch einen Detektor 52, sowie als Option eine Kompensationsstromquelle 54 mit einer Verknüpfung 56 und/oder einer Verknüpfung 58 auf. Dabei dient die Ausgangsstufe 38 lediglich zur weiteren Verstärkung des Ausgangssignals I des Differenzverstärkers 14 zu einem Treibersignal I' der Laserdiode 12. Die Auskopplung 40 dient zum Auskoppeln eines Signals f(I), das in einem Ermittlungsmodus über die zweite Rückführung 39 anteilig an den Rückführsignaleingang 18 des Differenzverstärkers 14 geführt wird.

Dabei gibt das Schwellenwertfilter 44 eine einstellbare Aktivierungsschwelle SW2 für eine Regelung über die zweite Rückführung vor, wobei die einstellbare Aktivierungsschwelle SW2 in einem Ermittlungsmodus auch hier zunächst kleiner oder zunächst größer als die Laserschwelle LS ist, die in der ersten Rückführung wirksam ist. Das über die Auskopplung 40 in die zweite Rückführung 39 eingekoppelte Signal I oder f(I) des Differenzverstärkers 14 wird in der Schwellenwertverknüpfung 46 mit der anfänglich vergleichsweise niedrigen einstellbaren Aktivierungsschwelle SW2 des Schwellenwertfilters 44 verknüpft. Dabei kann die Verknüpfung auch hier so geschehen, dass das Schwellenwertfilter 44 einen Strom bis zu einem vorgegebenen Maximalwert von der Schwellenwertverknüpfung 46 ziehen kann, so dass die Schwellenwertverknüpfung 46 nur dann ein Signal an die Dämpfung 48 weitergibt, wenn der durch das Schwellenwertfilter 44 vorgegebene Maximalwert durch das ausgekoppelte Signal f(I) überschritten wird.

Der den zweiten Schwellenwert SW2 überschreitende Teil des Signals f(I), beziehungsweise des Ausgangssignals I des Differenzverstärkers 14 wird von der Dämpfung 48 in einem Maße gedämpft, das eine stabile zweite Rückführung gewährleistet. Das gedämpfte Signal wird als Rückführsignal Ifb_2 der zweiten Rückführung über die Auskoppelschaltung 50 an den Rückführsignaleingang 18 des Differenzverstärkers 14 angelegt. Die optionalen Elemente 42, 54, 56, 58 realisieren Ausgestaltungen, die auch in Verbindung mit der Treiberschaltung 36a realisiert werden können und weiter unten näher erläutert werden. Um auch bei einem negativen Offset des Verstärkers 14 ein Treibersignal zu erzeugen, wird der Verstärker 14 entsprechend ausgesteuert. Er wird also so ausgesteuert, dass auch bei einem maximal möglichen negativen Offset ein positiver Treiberstrom auftritt.

Für die Ausgestaltungen der Fig. 4a und 4b gilt, dass das Treibersignal prinzipiell entweder über die erste Rückführung 37 oder über die zweite Rückführung 39 in jeweils gedämpfter Form zum Rückführsignaleingang 18 zurückgekoppelt werden kann. Die beiden Rückführungen konkurrieren daher miteinander. Dabei gewinnt immer die Rückführung, in der eine jeweils kleinere Aktivierungsschwelle wirksam ist: Qualitativ betrachtet subtrahiert die Rückführung mit der kleineren Aktivierungsschwelle einen kleineren Teil des Treibersignals und liefert damit ein größeres Rückführsignal an den Rückführsignaleingang 18. Entsprechend ergibt sich für das größere Rückführsignal eine kleinere Eingangssignaldifferenz am Differenzverstärker 14 und damit auch ein kleineres Treibersignal. Das kleinere Treibersignal reicht dann nicht mehr zur Überwindung der größeren Schwelle (Aktivierungsschwelle SW2 oder Laserschwelle LS) aus, so dass die Rückführung, in der die größere Schwelle wirksam ist, deaktiviert wird.

Startet man zum Beispiel einen Ermittlungsmodus, bei dem die in der zweiten Rückführung 39 wirkende zweite Aktivierungsschwelle SW2 zunächst niedriger ist die in der ersten Rückführung 37 wirkende Laserschwelle LS, ist die zweite Rückführung 39 aktiv und die Laserdiode 12 erzeugt kein Ausgangssignal im Sinn der oben genannten Konvention. Als Folge existiert auch keine relevante optische Kopplung 28 zwischen Laserdiode 12 und Fotodiode 26, so dass die erste Rückführung 37, die im Normalbetrieb über diese optische Kopplung 28 geschlossen wird, im Wesentlichen deaktiviert ist.

Bei allmählicher Erhöhung des einstellbaren Schwellenwertes SW2 wird in der Schwellenwertverknüpfung 46 der zweiten Rückführung 39 ein steigender Signalanteil subtrahiert, so dass das am Rückführsignaleingang 18 wirksame Rückführsignal absinkt. Entsprechend wird die Eingangssignaldifferenz des Differenzverstärkers 14 und damit auch das Treibersignal I größer. Wenn die einstellbare Aktivierungsschwelle SW2 größer als die erste Aktivierungsschwelle SW1 wird, erzeugt die Laserdiode 12 ein Ausgangssignal, was die erste Rückführung 37 aktiviert und die zweite Rückführung 39 deaktiviert. Der Übergang zwischen den Aktivitätszuständen "aktiv" und nicht aktiv" der zweiten Rückführung 39 zeigt damit ein Durchlaufen der ersten Aktivierungsschwelle SW1 an. Mit anderen Worten: Die Laserschwelle LS, oder allgemeiner, eine Aktivierungsschwelle SW1, die durch Treiberströme überschritten werden muss, um eine als Ausgangssignal relevante Abstrahlung optischer Leistung der Laserdiode 12 auszulösen, wird indirekt bestimmt als der Wert des Schwellenwertes SW2 der zweiten Rückführung 39, bei dem die zweite Rückführung 39 deaktiviert wird.

Die messtechnische Unterscheidung einer aktiven zweiten Rückführung 39 von einer inaktiven zweiten Rückführung 39 durch an der keine optische Kopplung aufweisenden zweiten, Rückführung 39 erfolgende Messungen erlaubt daher eine indirekte Bestimmung der Laserschwelle LS. Dazu koppelt die Auskoppelschaltung 50 ein Signal aus der zweiten Rückführung 39 aus, in dem sich das Signal f(I) als Rückführsignal Ifb_2 abbildet. Die Abbildung kann bspw. identisch sein, so dass ein Signal Ifb_2 sowohl in den Detektor 52 eingespeist als auch an den Rückführsignaleingang 18 geliefert wird..

Der Detektor 52 vergleicht das eingespeiste Rückführsignal Ifb_2 mit einem vorgegebenen dritten Schwellenwert SW3 und liefert bei Überschreitung oder Unterschreitung des dritten Schwellenwertes SW3 ein entsprechendes Signal an die Steuerung 24. Über die gestrichelte Verbindung zwischen den Blöcken 24 und 52 steuert die Steuerung 24 den Detektor 52 bspw. so, dass der Detektor 52 in einem durch die Steuerung 24 vorgegebenen Zeittakt sein Eingangssignal abtastet und mit dem dritten Schwellenwert SW3 vergleicht. Detektor 52 und Steuerung 24 bilden daher eine Teilschaltung, die einen Aktivitätszustand der zweiten Rückführung 39 überwacht. Solange der Detektor 52 eine Überschreitung des Schwellenwertes SW3 registriert, ist die zweite Rückführung 39 aktiv. Eine Unterschreitung zeigt dagegen eine nicht aktive zweite Rückführung 39 an. Der Wert der einstellbaren Aktivierungsschwelle SW2, bei dem ein solcher Wechsel zwischen zwei Aktivitätszuständen der zweiten Rückführung 39 auftritt, entspricht dann dem Wert der Laserschwelle LS.

Der Verfahrensaspekt der Erfindung kann daher durch die folgenden Schritte realisiert werden: Speisen einer mit der ersten Rückführung 37 um eine Beeinflussung des Rückführsignals konkurrierenden zweiten Rückführung 39 mit einem von dem Treibersignal I, I' abhängigen Signal f(I), wobei in der zweiten Rückführung 39 eine einstellbare Aktivierungsschwelle SW2 wirksam ist, Erfassen eines Aktivitätszustandes der zweiten Rückführung 39, Verändern der einstellbaren Aktivierungsschwelle SW2 so, dass sich der Aktivitätszustand der zweiten Rückführung 39 ändert, und Bestimmen der Laserschwelle LS als Wert der einstellbaren Aktivierungsschwelle SW2 bei einer Änderung des Aktivitätszustandes der zweiten Rückführung 39.

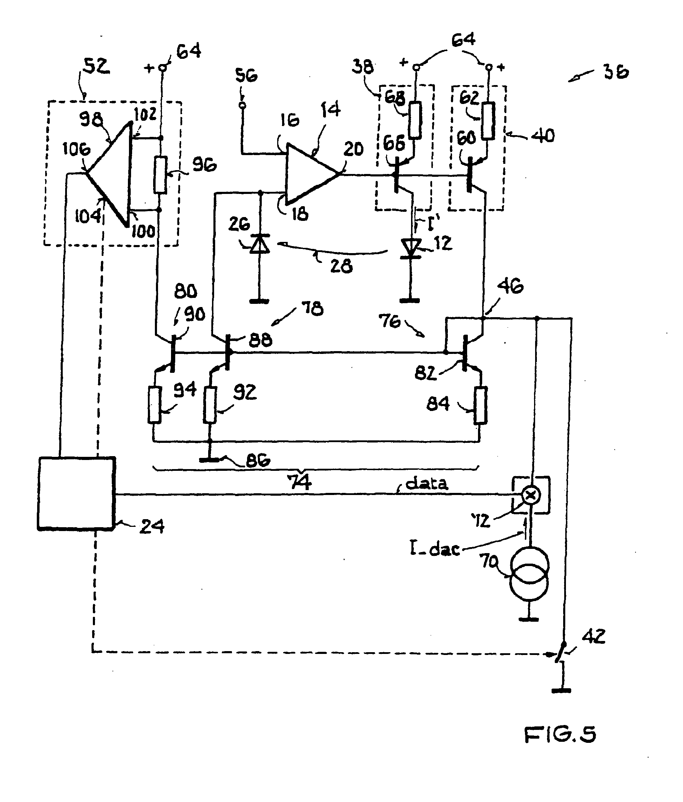

Figur 5 zeigt einen Schaltplan als Beispiel möglicher schaltungstechnischer Realisierungen verschiedener Blöcke aus der Figur 4. So kann die Auskopplung 40 durch einen Transistor 60 erfolgen, der über einen Emitterwiderstand 62 an ein Versorgungspotential 64 angeschlossen ist, der durch das Ausgangssignal des Differenzverstärkers 14 gesteuert wird, und dessen Kollektor mit der Schwellenwertverknüpfung 46 verbunden ist. Bei der Treiberschaltung 36 nach Fig. 5 kann es sich bei dem Ausgangssignal des Differenzverstärkers um eine Spannung oder einen Strom handeln. Die Ausgangsstufe 38 kann ebenfalls durch einen Transistor 66 realisiert sein, der über einen Emitterwiderstand 68 an das Versorgungspotential 64 angeschlossen wird, der ebenfalls durch das Ausgangssignal 1 des Differenzverstärkers 14 gesteuert wird, und dessen Kollektorstrom als Treibersignal I' der Laserdiode 12 dient. Das Schwellenwertfilter 44 kann als Digital-Analog-Konverter realisiert sein, der einen Referenzstrom I_dac einer Stromquelle 70 nach Maßgabe eines von der Steuerung 24 ausgegebenen data-Worts gewichtet, was durch die Verknüpfung 72 repräsentiert wird. Die Gewichtung erfolgt so, dass das Schwellenwertfilter 44 einen Strom variabler Stärke, aber vorgegebener Maximalstärke von der Schwellenwertverknüpfung 46 subtrahiert.

Ein Stromspiegel 74, der drei Zweige 76, 78 und 80 aufweist, spiegelt einen im ersten Zweig 76 von der Schwellenwertverknüpfung 46 über einen Transistor 82 und einen Widerstand 84 zu einem Massepotential 86 fließenden Strom als Rückführstrom Ifb_2 in die anderen beiden Zweige 78 und 80, die ebenfalls je einen Transistor 88, 90 und Emitterwiderstand 92, 94 aufweisen. Der Kollektor des Transistors 88 des zweiten Zweiges 78 ist mit dem Rückführsignaleingang 18 des Differenzverstärkers 14 verbunden und schließt damit die zweite Rückführung 39.

Die in der Figur 4 als Block 48 dargestellte Dämpfung ergibt sich bei der Ausgestaltung nach Figur 5 durch das Übersetzungsverhältnis der Ströme in den Zweigen 76 und 78. Der in den dritten Zweig 80 gespiegelte Strom stellt einen aus der zweiten Rückführung ausgekoppelten Strom dar, so dass der dritte Zweig 80 in Verbindung mit den beiden anderen Zweigen 76, 78 des Stromspiegels 74 die Funktion der Auskoppelschaltung 50 aus der Figur 4 repräsentiert. Dabei können die Transistoren 82, 88, 90 und Widerstände 84, 92, 94 so dimensioniert werden, dass in den als Messzweig dienenden dritten Zweig 80 ein anderer Strom eingespeist wird als in den als Rückführzweig dienenden zweiten Zweig 78. Durch einen höheren Strom im Messzweig 80 kann zum Beispiel der Spannungsabfall über einem Messwiderstand 96 vergrößert werden, was die Empfindlichkeit der Messung steigert. Der Detektor 52 aus der Figur 4 wird z. B. durch einen Komparator 98 in Verbindung mit dem Messwiderstand 96 realisiert. Der Komparator 98 kann als "Latched Comparator" oder "getakteter Komparator" ausgeführt sein. Ein solcher getakteter Komparator besitzt zusätzlich zu Differenzeingängen 100 und 102 einen Takteingang 104, der mit der Steuerung 24 verbunden ist. Mit einem eingeschalteten Taktsignal wird eine positive Rückkopplung innerhalb des Komparators 98 aktiviert, die den Zustand am Ausgang 106 des Komparators 98 festhält. Dieser ist dann, d.h. bis zum nächsten Impuls des Taktsignals, unabhängig vom Eingangssignal. Durch die positive Rückkopplung wird die Verstärkung des Komparators 98 im Umschaltzeitpunkt sehr groß, so dass bereits kleinste Änderungen zwischen den Differenzeingängen 100 und 102 zu eindeutigen Signalen am Ausgang 106 führen. Der dritte Schwellenwert SW3 kann dabei auf verschiedenen Arten beim Schaltungsentwurf realisiert werden. In Frage kommt zum Beispiel ein entsprechend dimensionierter Offset des Komparators 98 oder eine zusätzliche Stromsenke, die am Kollektor des Transistors 80 einen Strom entnimmt, der dem dritten Schwellenwert SW3 entspricht.

Im Folgenden wird unter erneutem Bezug auf die Fig. 4b erläutert, wie die so bestimmte erste Aktivierungsschwelle im Rahmen einer Ausgestaltung im Betrieb der Treiberschaltung kompensiert wird.

Soweit wie bisher beschrieben, wurde eine Laserschwelle LS der Laserdiode 12 als minimaler Wert der Treiberstromstärke bestimmt, bei dem die Laserdiode 12 ein Ausgangssignal im Sinne der oben genannten Konvention abstrahlt. Die Treiberstromstärke wird letztlich durch den Differenzverstärker 14 erzeugt, der selbst Toleranzen in seinem Eingangs-/Ausgangssignalverhalten aufweisen kann.

Für ein Verständnis weiterer Ausgestaltungen wird darauf hingewiesen, dass Kennlinien eines Differenzverstärkers eine ähnliche Gestalt besitzen wie Kennlinien von Laserdioden, wobei Offsetstromeinflüsse bei einer Anordnung aus Bauteil 12 und Differenzverstärker 14 die Kennlinie 30 der Laserdiode 12 sowohl nach links als auch nach rechts verschieben können. Beim Betrieb einer Anordnung aus einer Laserdiode 12 mit einem Differenzverstärker 14 ergibt sich daher eine Aktivierungsschwelle f(SW1) für das Ausgangssignal der Laserdiode, die von Toleranzen der Laserdiode und von Offseteinflüssen des Differenzverstärkers abhängt.

Die Figur 3 zeigt typische (idealisierte) Kennlinien, wie sie sich für solche Abhängigkeiten ergeben. Dabei ist das Ausgangssignal P der Laserdiode 12 über dem Referenzsignal Iref aufgetragen, wobei die Kennlinien mit geöffneter Schleife, also mit konstantem Signal am Rückführsignaleingang 18 aufgenommen worden sind. Im Unterschied zur Fig. 2, bei der die Leistung P über dem Treiberstrom I, also über einem Wert am Ausgang des Differenzverstärkers aufgetragen ist, ist die Leistung P bei der Fig. 3 also über einen Wert Iref am Eingang des Differenzverstärkers aufgetragen. Bei dieser Auftragung bildet sich die Laserschwelle LS, oder allgemeiner, die erste Aktivierungsschwelle SW1 in einen Wert f(SW1) ab, mit dem der Differenzverstärker eingangsseitig auszusteuern ist, um ausgangsseitig einen der ersten Aktivierungsschwelle SW1 entsprechenden Treiberstrom bereitzustellen.

Im Einzelnen zeigt die Figur 3 zwei (idealisierte) Kennlinien 32 und 34, wobei die Ziffer 32 eine Optimalkennlinie bezeichnet. Die Optimalkennlinie 32 zeichnet sich dadurch aus, dass bereits eine kleine, von null abweichende Änderung des Referenzsignals Iref eine von Null abweichende Änderung des Ausgangssignals P zur Folge hat.

Wegen der Toleranzen von Differenzverstärkern und Laserdioden treten jedoch im Regelfall verschobene Kennlinien auf. Die gestrichelt dargestellte Kennlinie 34 geht aus der Optimalkennlinie 32 durch eine Verschiebung nach rechts hervor, was einem negativen resultierenden Gesamtoffset entspricht: Wenn man die Optimalkennlinie 32 als Funktion von Iref betrachtet, so ist die Kennlinie 34 als gleiche Funktion mit dem Argument (Iref- Ioff) zu bilden, wobei Ioff dem resultierenden Gesamtoffset entspricht.

Zur Kompensation dieses Gesamtoffsets dient die bereits genannte Kompensationsstromquelle 54 mit der Verknüpfung 56 und/oder der Verknüpfung 58. Nach dem Bestimmen der ersten Aktivierungsschwelle SW1 = SW2 wird das Schwellenwertfilter 44 auf einen geringfügig kleineren Wert eingestellt, um die erste Rückführung für die Kompensation zu deaktivieren. Dadurch wird für den Differenzverstärker 14 im Abgleichmodus eine Betriebsbedingung erzeugt, die weitestgehend den durch die Aktivierungsschwelle SW1 bestimmten Betriebsbedingungen entspricht, die sich im regulären Betrieb bei einer Steuerung der Ausgangsleistung der Laserdiode ergeben. Als erwünschte Folge werden Fehler beim Abgleich, die sich durch eine endliche Schleifenverstärkung einstellen könnten, minimiert. Ohne Kenntnis der Aktivierungsschwelle SW1 müsste der beim Abgleich wirksame zweite Schwellenwert SW2 auf einen wesentlich kleineren Wert eingestellt werden, um sicherzustellen, dass auch Laserdioden mit einer am unteren Rand des Toleranzintervalls liegenden Laserschwelle (im oben genannten Beispiel: am unteren Rand des Intervalls (10 mA, 50ma) noch nicht aktiviert werden. Die genannte Gleichsetzung zwischen SW1 und SW2 bei der Änderung der Aktivität der zweiten Rückführung gilt für den Spezialfall, dass die Ströme in den Stromquellen 38 und 40 gleich sind. Bevorzugt werden diese Stromquellen 38, 40 jedoch so dimensioniert, dass der Strom der Stromquelle 40 kleiner als der Strom der Stromquelle 38 ist. Wenn zum Beispiel gilt, dass der Strom in der Stromquelle 38 zum Beispiel dem x-fachen des Stroms der Stromquelle 40 entspricht, ändert sich die Aktivität der zweiten Rückführung entsprechend bei einem Wert SW2, der Gleichung SW1 = x * SW2 genügt. Daher wird im Allgemeinen dieser Zusammenhang zur Ermittlung der Aktivierungsschwelle verwendet.

Ergänzend wird der Schalter 42 geschlossen und der Referenzsignalgenerator 22 wird durch die Steuerung 24 deaktiviert, so dass dieser kein Signal mehr an den Referenzsignaleingang 16 des Differenzverstärkers 14 liefert. Wegen der anderen Topologie würde der Schalter 42 in der Fig. 5 geöffnet werden.

Besitzt die Anordnung die vor der Adaption die nach rechts verschobene Kennlinie 34 aus der Figur 3, so ergibt sich bei abgeschaltetem Referenzsignal Iref kein Ausgangssignal, das über die zweite Rückführung als gedämpftes Signal Ifb_2 an den Rückführsignaleingang 18 des Differenzverstärkers 14 zurückgeführt werden könnte, da die in der zweiten Rückführung wirksame zweite Aktivierungsschwelle SW2 vorher auf den Wert der ersten Aktivierungsschwelle SW1 (oder einen geringfügig abweichenden Wert) eingestellt wurde. Die Auskoppelschaltung 50 koppelt ein Signal aus der zweiten Rückführung aus, in dem sich das Rückführsignal Ifb_2 abbildet. Die Abbildung kann bspw. identisch sein, so dass ein Signal Ifb_2 in den Detektor 52 eingespeist wird. Im genannten Fall ist dieses Signal zunächst gleich null, beziehungsweise kleiner als ein Schwellenwert SW3.
Der Detektor 52 vergleicht das eingespeiste Rückführsignal Ifb_2 mit dem vorgegebenen Schwellenwert SW3 und liefert bei Überschreitung oder Unterschreitung des dritten Schwellenwertes SW3 ein entsprechendes Signal an die Steuerung 24. Über die gestrichelte Verbindung zwischen den Blöcken 24 und 52 steuert die Steuerung 24 den Detektor 52 bspw. so, dass der Detektor 52 in einem durch die Steuerung 24 vorgegebenen Zeittakt sein Eingangssignal abtastet und mit dem dritten Schwellenwert SW3 vergleicht. Der dritte Schwellenwert SW3 kann bspw. so bemessen sein, dass er in der Auftragung der Figur 3 dem Wert f(SW3) entspricht. Dabei ist der Wert f(SW3) in der Figur 3 aus Gründen der Unterscheidbarkeit relativ hoch auf der P-Achse eingezeichnet und wird bei Realisierungen der Erfindung noch näher an den Koordinatenursprung herangeführt.

Wenn der dritte Schwellenwert SW3 zu Beginn unterschritten wird, wie es im Fall der Kennlinie 34 aus der Figur 3 der Fall ist, löst die Steuerung 24 über die Kompensationsstromquelle 54 eine schrittweise Veränderung eines Kompensationsstroms aus, der über die Verknüpfung 56 und an den Referenzsignaleingang 16 und/oder über die Verknüpfung 58 an den Rückführsignaleingang 18 des Differenzverstärkers 14 angelegt wird, um den dort wirksamen Offsetstrom sowie Laserschwelle LS der Laserdiode 12 zu kompensieren. Um die Wirkung eines positiven (negativen) Kompensationsstroms am Referenzsignaleingang 16 zu erzielen, muss eine Einspeisung in den Rückführsignaleingang 18 mit negativem (positivem) Vorzeichen erfolgen. Wie bereits erwähnt, entspricht die Kennlinie 34 einem negativen Gesamt-Offset, so dass die Steuerung 24 in diesem Fall einen positiven Kompensationsstrom der Kompensationsstromquelle 54 einstellt, wenn der Kompensationsstrom über den Referenzsignaleingang 16 eingespeist wird. Über die zweite Rückführung bildet sich dies in einer Veränderung des Rückführsignals Ifb_2 ab.

Im Fall der Kennlinie 34 aus der Figur 3 bewirkt das Einprägen eines positiven Kompensationsstroms in die Verknüpfung 56 eine Verschiebung der Kennlinie 34 nach links. Dadurch sinkt der Schnittpunkt der Kennlinie 34 mit der P-Achse ab. Bei wiederholtem Erhöhen des positiven Kompensationsstroms durch die Steuerung 24 in Verbindung mit der Kompensationsstromquelle 54 rutscht die Kennlinie 34 sukzessive weiter nach links, bis der Wert f(SW3) erreicht wird. Dieses Erreichen wird von dem Detektor 52 detektiert und von der Steuerung 24 registriert. Die Steuerung 24 befiehlt der Kompensationsstromquelle 54, den zuletzt verwendeten Kompensationsstromwert festzuhalten und im späteren Betriebsmodus mit aktivierter erster Rückführung zu verwenden. Ferner öffnet die Steuerung 24 im späteren Betriebsmodus den Schalter 42 in der Fig. 3, um die zweite Rückführung im Normalbetrieb zu deaktivieren. Die gleiche Wirkung einer Deaktivierung der zweiten Rückführung wird bei der Ausgestaltung nach der Fig. 5 durch ein Schließen des Schalters 42 erzielt.

## Patentansprüche

1. Verfahren zur Bestimmung der Laserschwelle (SW1) einer Laserdiode (12), die von einer Treiberschaltung (36a) in Abhängigkeit von einem ersten Signal in einer ersten Rückführung (37) und einem zweiten Signal in einer zweiten Rückführung (39) betrieben wird, wobei die erste Rückführung (37) über eine optische Kopplung (28) von einem optischen Ausgangssignal der Laserdiode (12) gespeist wird, **dadurch gekennzeichnet, dass** die zweite Rückführung (39) von einem zwischen der Treiberschaltung (36a) und der Laserdiode (12) abgenommenen elektrischen Signal (f(I)) gespeist wird, das elektrische Signal (f(I)) mit einer einstellbaren Aktivierungsschwelle (SW2) verglichen wird, nur ein Anteil des elektrischen Signals (f(I)), der die einstellbare Aktivierungsschwelle (SW2) übersteigt, an die Treiberschaltung (36a) weitergegeben wird, so dass die zweite Rückführung (39) nur beim Auftreten eines solchen Anteils aktiv ist, die einstellbare Aktivierungsschwelle (SW2) so verändert wird, dass sich der Aktivitätszustand der zweiten Rückführung (39) ändert, und die Laserschwelle der Laserdiode (12) in Abhängigkeit von dem Wert der einstellbaren Aktivierungsschwelle (SW2) bei einer Änderung des Aktivitätszustandes der zweiten Rückführung (39) bestimmt wird.

2. Treiberschaltung (36a), die die Laserschwelle einer Laserdiode (12) bestimmt, wobei die Treiberschaltung (36a) ein Treibersignal (I, I') und die Laserdiode (12) ein vom Treibersignal (I, I') abhängiges Ausgangssignal erzeugt, mit einer ersten Rückführung (37) und einer zweiten Rückführung (39), wobei die erste Rückführung (37) zur Einspeisung eines Teils des Ausgangssignals über eine optische Kopplung (28) eingerichtet ist, **dadurch gekennzeichnet, dass** die zweite Rückführung (39) durch einen elektrischen Anschluss (41) an eine das Treibersignal (I, I') führende Verbindung zwischen der Treiberschaltung (36a) und der Laserdiode (12) zur Einspeisung eines elektrischen Signals (f(I) eingerichtet ist, und ferner dazu eingerichtet ist,
- das elektrische Signal (f(I) mit einer einstellbaren Aktivierungsschwelle (SW2) zu vergleichen,
- nur einen Anteil des elektrischen Signals (f(I), der die einstellbare Aktivierungsschwelle (SW2) übersteigt, an die Treiberschaltung (36a) weiterzugeben, so dass die zweite Rückführung (39) nur beim Auftreten eines solchen Anteils aktiv ist,
- die einstellbare Aktivierungsschwelle (SW2) so zu verändern, dass sich der Aktivitätszustand der zweiten Rückführung (39) ändert, und
- die Laserschwelle der Laserdiode (12) in Abhängigkeit von dem Wert der einstellbaren Aktivierungsschwelle (SW2) bei einer Änderung des Aktivitätszustandes der zweiten Rückführung (39) zu bestimmen.

3. Treiberschaltung (36a) nach Anspruch 2 **dadurch gekennzeichnet, dass** die zweite Rückführung (39) ein Schwellenwertfilter (44) aufweist, das nur Signale passieren lässt, die den einstellbaren Schwellenwert (SW2) überschreiten.

4. Treiberschaltung (36a) nach Anspruch 3, **gekennzeichnet durch** eine steuerbare Stromquelle als Schwellenwertfilter (44), die einen Strom bis zu einer dem einstellbaren Schwellenwert (SW2) entsprechenden Stromstärke aufnimmt oder ausgibt.

5. Treiberschaltung (36a) nach wenigstens einem der Ansprüche 2 bis 4, **dadurch gekennzeichnet, dass** die Treiberschaltung (36a) einen Differenzverstärker (14) mit einem Ausgang (20), der das Treibersignal (I, I') bereitstellt, einem Referenzsignaleingang (16), der von einem Referenzsignalgenerator (22) gespeist wird und einen Rückführsignaleingang (18), aufweist, der sowohl mit der ersten Rückführung (37) als auch mit der zweiten Rückführung (39) gekoppelt ist.

6. Treiberschaltung (36a) nach Anspruch 5, **dadurch gekennzeichnet, dass** die zweite Rückführung (39) eine Auskoppelschaltung (50) aufweist, die ein Rückführsignal aus der zweiten Rückführung (39) auskoppelt und einer Teilschaltung (24, 52) zuführt, die einen Aktivitätszustand der zweiten Rückführung (39) überwacht.

7. Treiberschaltung (36a) nach Anspruch 6, **dadurch gekennzeichnet, dass** die Auskoppelschaltung (50) einen Stromspiegel (74) aufweist, der einen aus dem Differenzverstärker (14) in die zweite Rückführung (39) eingespeisten Strom sowohl in einen zum Rückführsignaleingang (18) führenden Stromzweig (78) als auch in einen Messzweig (80) der Teilschaltung (24, 52), abbildet.

8. Treiberschaltung (36a) nach Anspruch 7, **dadurch gekennzeichnet, dass** die Teilschaltung (24, 52) einen Detektor (52) aufweist, der eine Signalstärke des ausgekoppelten Rückführsignals erfasst und an eine Steuerung (24) übergibt.

9. Treiberschaltung (36a) nach Anspruch 8, **dadurch gekennzeichnet, dass** der Detektor (52) die Signalstärke periodisch abtastet.

10. Treiberschaltung (36a) nach wenigstens einem der Ansprüche 8 oder 9, **dadurch gekennzeichnet, dass** der Detektor (52) als getakteter Komparator (98) ausgeführt ist.

11. Treiberschaltung (36a) nach wenigstens einem der Ansprüche 6 bis 10, **dadurch gekennzeichnet, dass** die Teilschaltung (24, 52) zusätzlich eine Offset-Kompensationssignalquelle (54) aufweist, und dass die Teilschaltung (24, 52, 54) nach Abspeicherung des Maßes (SW1) für die Laserschwelle unter Verwendung dieses Maßes (SW1) ein Kompensationssignal bildet und speichert, das die erste Aktivierungsschwelle (SW1) bis auf einen definierten Rest-Offset kompensiert, und dass die Kompensationssignalquelle (54) das gespeicherte Kompensationssignal zusätzlich zu einem vom Referenzsignalgenerator (22) gelieferten Referenzsignal in den Referenzsignaleingang (16), oder den Rückführsignaleingang (18) einspeist.
